# EUROPEAN PATENT SPECIFICATION

(11) **EP 4 575 538 B1**
(45) Date of publication and mention of the grant of the patent: **16.09.2026**
(21) Application number: 23873201.0
(22) Date of filing: 27.09.2023
(51) Int. Cl.: G01R 31/3842, G01R 31/3832, G01R 31/367, G01R 31/392, G01R 31/3835, H01M 10/42, H01M 10/48, H01M 10/0525

(54) **SYSTEM AND METHOD FOR DIAGNOSING DEGRADATION STATE OF BATTERY**
SYSTEM UND VERFAHREN ZUR DIAGNOSE DES DEGRADATIONSZUSTANDS EINER BATTERIE
SYSTÈME ET PROCÉDÉ DE DIAGNOSTIC D'ÉTAT DE DÉGRADATION DE BATTERIE

(30) Priority: 27.09.2022 KR 20220122902
(43) Date of publication of application: 25.06.2025
(73) Proprietor: LG Energy Solution, Ltd., Seoul 07335 (KR)
(72) Inventor: LIM, Jin Hyung, Daejeon 34122 (KR); KOH, Dong Wook, Daejeon 34122 (KR)
(74) Representative: Plasseraud IP
(86) International application number: PCT/KR2023/015014
(87) International publication number: WO 2024/072092

(56) References cited:
- KR-A- 20160 048 585
- KR-A- 20170 022 855
- KR-A- 20190 036 982
- KR-A- 20200 049 596
- KR-A- 20200 069 203
- YIZHAO GAO ET AL: "Estimation of State-of-Charge and State-of-Health for Lithium-Ion Degraded Battery Considering Side Reactions", JOURNAL OF THE ELECTROCHEMICAL SOCIETY, vol. 165, no. 16, 29 December 2018 (2018-12-29), pages A4018 - A4026, XP055717677, ISSN: 0013-4651, DOI: 10.1149/2.0981816jes

## Description

### [TECHNICAL FIELD]

### CROSS-REFERENCE TO RELATED APPLICATION

This application claims priority to and the benefit of Korean Patent Application No. 10-2022-0122902 filed in the Korean Intellectual Property Office on September 27.

### TECHNICAL FIELD

The present disclosure relates to a system and method for diagnosing a degradation state of a battery, and more particularly, to a system and method for improving the performance of diagnosing the degradation state.

### [BACKGROUND ART]

Generally, an electric vehicle or a hybrid electric vehicle uses electric energy stored in a battery as an energy source. For example, lithium-ion polymer batteries are widely used as batteries for electric vehicles, and research on the batteries are being actively performed.

As the electric vehicle or the hybrid electric vehicle is driven by energy charged in the battery, it is important to not only diagnose (or predict) the current state of the battery, but also a degradation state of the battery.

For example, a battery capacity may be reduced by a side reaction, such as solid electrolyte interphase film formation, and the side reaction may be considered to diagnose the degradation state of the battery. In other words, a side reaction state of an electrode may be predicted and the degradation state of the battery may be diagnosed based on a result of the prediction.

When the degradation state of the battery (or the side reaction of the electrode) is diagnosed, various prediction models may be used. For example, physics-based models such as a Doyle Fuller Newman (DFN) model, a single particle model (SPM), an enhanced single particle model (ESPM), etc., may be used to diagnose the degradation state of the battery.

However, the above-described physics-based models are models that formalize the physical movement of particles inside the battery using complex differential equations, and the degradation state of the battery may be diagnosed relatively accurately, but computational complexity is high due to mathematical complexity.

Document Yizhao Gao ET AL: "Estimation of State-of-Charge and State of Health for Lithium-Ion Degraded Battery Considering SideReactions", Journal of The Electrochemical Society, vol. 165,no. 16, 29 December 2018 (2018-12-29), pages A4018-A4026 discloses an example of background art**.[DISCLOSURE]**

### [TECHNICAL PROBLEM]

At least one of various embodiments of the present disclosure aim to provide a system and method for diagnosing a degradation state of a battery to improve the performance of diagnosing the degradation state.

At least one of various embodiments of the present disclosure aim to provide a system and method for diagnosing a degradation state of a battery to predict a side reaction state based on an equilibrium potential of an electrode.

At least one of various embodiments of the present disclosure aim to provide a system and method for diagnosing a degradation state of a battery to predict a side reaction state using an open circuit voltage (OCV) model having a lower mathematical complexity than a physics-based model.

### [TECHNICAL SOLUTION]

A diagnosis system for diagnosing a state of a battery according to various embodiments is defined in the appended claims.

An operating method of a diagnosis system for diagnosing a state of a battery according to various embodiments is also provided.

### [ADVANTAGEOUS EFFECTS]

A system and method for diagnosing a degradation state of a battery according to various embodiments disclosed herein may shorten a diagnosis time while improving the accuracy of diagnosing the degradation state by using an open circuit voltage (OCV) model having a lower mathematical complexity than a physics-based model.

The effects that may be obtained from the present document are not limited to the effects mentioned above.

### [DESCRIPTION OF DRAWINGS]

FIG. 1A is a view schematically showing a configuration of a diagnosis system for diagnosing a state of a battery according to various embodiments.
FIG. 1B is a view schematically showing a configuration of a diagnosis apparatus according to various embodiments.
FIG. 2 is a view for describing an operation in which a potential of an electrode is obtained by a diagnosis apparatus according to various embodiments.
FIGS. 3A to 3G show a result of performance comparison between a diagnosis apparatus according to various embodiments and a diagnosis apparatus according to a comparative embodiment.
FIG. 4 is a flowchart showing a battery diagnosis operation of a diagnosis system according to various embodiments.
FIG. 5 shows parameters for describing a model for predicting a side reaction rate according to various embodiments.

### [MODE FOR INVENTION]

Hereinafter, some embodiments of the present disclosure will be described in detail with reference to the exemplary drawings. In adding reference numerals to components of each drawing, it should be noted that the same components are given the same reference numerals even though they are indicated in different drawings. When an embodiment of the present disclosure is described, a detailed description of related well-known configurations or functions will be omitted if it obscures the subject matter of the present disclosure.

To describe a component of an embodiment of the present disclosure, terms such as first, second, A, B, (a), (b), etc., may be used. These terms are used merely for distinguishing one component from another component and do not limit the component to the essence, sequence, order, etc., of the component. All of the terms used herein including technical or scientific terms have the same meanings as those generally understood by an ordinary skilled person in the related art unless they are defined otherwise. Generally, the terms defined in a generally used dictionary should be interpreted as having the same meanings as the contextual meanings of the relevant technology and should not be interpreted as having ideal or exaggerated meanings unless they are clearly defined in the present document.

Moreover, it should be appreciated that various embodiments of the present document and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if a component (e.g., a first component) is referred to, with or without the term "operatively" or "communicatively", as "coupled with," "coupled to," "connected with," or "connected to" another component (e.g., a second component), it means that the component may be coupled with the other component directly (e.g., wiredly or wirelessly), or via a third component.

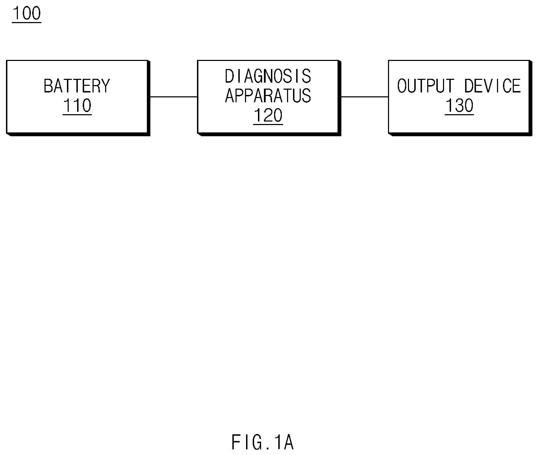

FIG. 1A is a view schematically showing a configuration of a diagnosis system for diagnosing a state of a battery according to various embodiments.

Referring to FIG. 1A, a diagnosis system 100 according to various embodiments may include a battery 110, a diagnosis apparatus 120, and an output device 130.

According to various embodiments, the battery 110 may include a cell assembly where a plurality of unit cells that are repeatedly chargeable/dischargeable are connected in series or in parallel. The unit cell may be an electric double-layer capacitor including an ultracapacitor or a well-known secondary battery such as a lithium-ion battery, a lithium-polymer battery, a nickel cadmium battery, a nickel hydrogen battery, a nickel zinc battery, etc.

According to various embodiments, the output device 130 may output information related to an operation of the diagnosis system 100. According to an embodiment, the output device 130 may include a sound output device (e.g., a speaker) configured to output auditory information and/or a display configured to output visual information. For example, at least some of the visual information and/or the auditory information may include a diagnosis result for the battery 110 (e.g., a state of the battery 100). However, this is merely an example, and various embodiments are not limited thereto. For example, the output device 130 may include a haptic module (e.g., a motor, a piezoelectric element, an electrical stimulation device, etc.) configured to output tactile information.

According to various embodiments, the diagnosis apparatus 120 may process an overall operation of the diagnosis system 100. According to an embodiment, the diagnosis apparatus 120 may diagnose (or predict) the state of the battery 110. The diagnosis apparatus 120 may output the state of the battery 110 through the output device 130. For example, the state of the battery 110 diagnosed by the diagnosis apparatus 120 may be the degradation state of the battery 110. However, this is merely an example, and various embodiments are not limited thereto. For example, the diagnosis apparatus 120 may measure a state of charge (SOC) of the battery 110, a change in an initial capacity of the battery 110, etc., at designated time intervals (e.g., in real time) and output the same as at least a part of the diagnosis result.

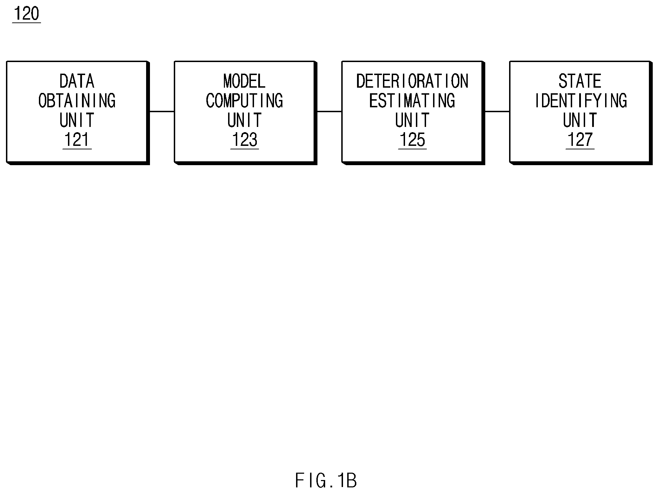

According to an embodiment, the diagnosis apparatus 120 may diagnose the degradation state of the battery 110 by using an open circuit voltage (OCV) model (e.g., a lumped OCV model). The OCV model uses a functional dependence of the side reaction state (e.g., a side reaction rate) on an equilibrium potential of the electrode, and is modeled based on a higher level of contraction than a general physics-based model (e.g., an SPM model), having low mathematical complexity. Thus, the diagnosis apparatus 120 may accurately and quickly predict the side reaction state of the electrode with respect to the equilibrium potential of the electrode by using the OCV model, thereby improving the diagnosis performance with respect to the degradation state. The diagnosis apparatus 120 using the OCV model will be described in detail with reference to FIG. 1B.

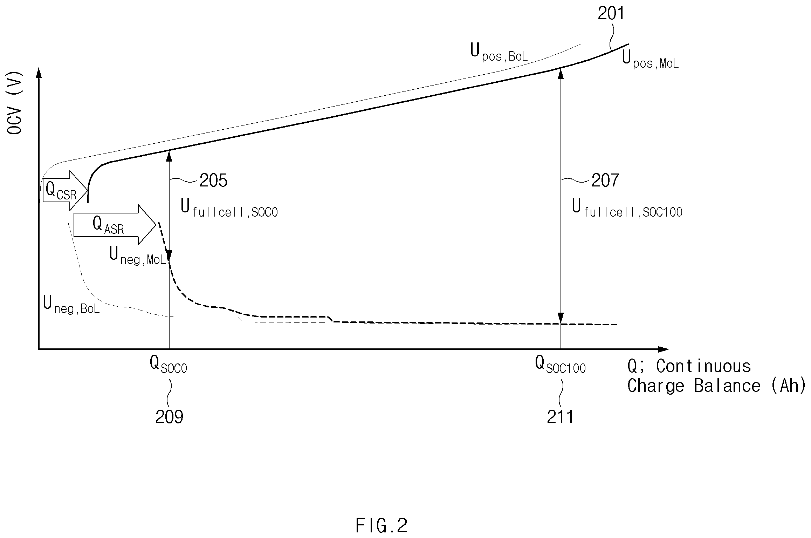

FIG. 1B is a view schematically showing a configuration of a diagnosis apparatus according to various embodiments. FIG. 2 is a view for describing an operation in which a potential of an electrode is obtained by a diagnosis apparatus according to various embodiments.

Referring to FIG. 1B, the diagnosis apparatus 120 may include a data obtaining unit 121, a model computing unit 123, a deterioration estimating unit 125, and a state identifying unit 127.

According to various embodiments, the data obtaining unit 121 may obtain battery information related to the battery 110. The battery information may include an SOC of the battery 110 and the amount of side reaction accumulated in the electrode. According to an embodiment, the data obtaining unit 120 may obtain a voltage, a current, and a temperature of the battery 110 and obtain the battery information based on them. However, this is merely an example, and various embodiments are not limited thereto. For example, various information related to the battery 110 such as charging cycle information, etc., in addition to the above-described information may be obtained as the battery information. For example, the data obtaining unit 121 may include at least one sensor configured to obtain the battery information.

According to various embodiments, the model computing unit 123 may obtain at least one parameter available to diagnose the battery 100 based on the battery information obtained by the data obtaining unit 121. For example, the model computing unit 123 may obtain a side reaction state (e.g., a side reaction rate) of the electrode as at least a part of the parameter.

According to an embodiment, the model computing unit 123 may obtain a potential of the electrode, e.g., an equilibrium potential of a negative electrode and a positive electrode and a capacity differential value of the equilibrium potential, as part of an operation of obtaining the side reaction state. For example, the model computing unit 123 may obtain the potential of the electrode using the SOC obtained through the data obtaining unit 121 and the amount of side reaction accumulated in the electrode, and predict the side reaction state for the electrode based on the same.

The operation of obtaining the potential of the electrode by the model computing unit 123 will be described in detail with reference to FIG. 2.

Referring to FIG. 2, the model computing unit 123 may compute a theoretical capacity for the electrode and compute an electrode OCV change profile predicted with respect to a charge/discharge capacity by using the theoretical capacity. The theoretical capacity may include a negative theoretical capacity, which is an inherent capacity of the negative electrode (or a negative electrode active material), and a positive theoretical capacity, which is an inherent capacity of the positive electrode (or a positive electrode active material). The OCV change profile may be a prediction result of an OCV changing with the charge/discharge capacity.

The model computing unit 123 may locate the OCV change profile of the electrode on a charge balance axis (e.g., continuous charge balance Qccb) that defines an accumulative state of the charge/discharge capacity. When a charge current is applied to a cell from a time point of 0 at which the cell is assembled first, a value increases by a charge capacity on the charge balance axis, and when a discharge current is applied to the cell, a value decreases by a discharge capacity on the charge balance axis. For example, on the charge balance axis, a positive electrode OCV switch profile may be moved (201) by a positive electrode side reaction amount, and a negative electrode OCV profile may be moved (203) by a negative electrode side reaction amount.

The model computing unit 123 may identify points 209 and 211 at which differences 205 and 207 between the positive electrode OCV change profile and the negative electrode OCV change profile correspond to preset values, and a potential of the electrode may be obtained based on the identified points 209 and 211. For example, a preset value used to identify a position of the charge balance axis at which the potential is obtained may be a potential of full cells (e.g., a potential of the full cells at an OCV of 0 % and a potential of the full cells at an OCV of 100 %) and may be previously stored inside or outside the diagnosis system 100.

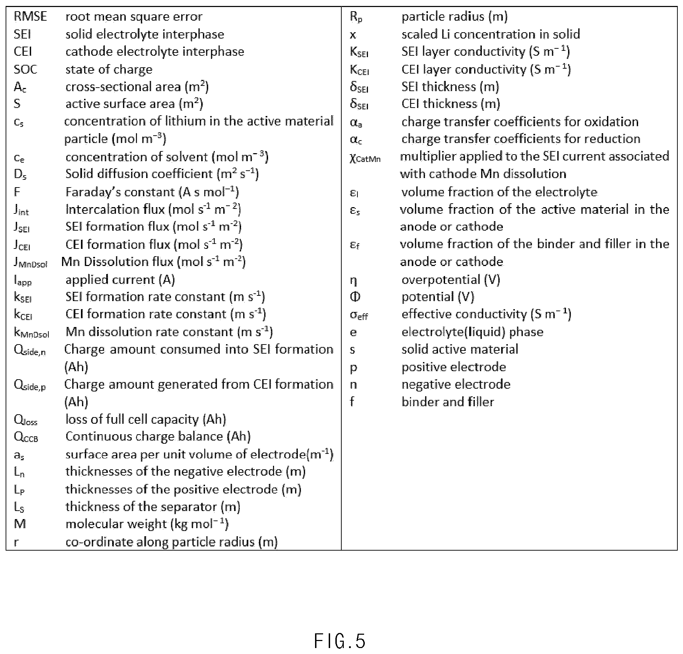

In this regard, the model computing unit 123 may output an electrode potential with inputs of a charge state of the battery 110 and a side reaction amount of the electrode through an OCV model obtained from [Equation 1] to [Equation 11] described below. Parameters shown in FIG. 5 may be referred to in relation to the following equations.

For example, the model computing unit 123 may obtain an electrode potential as described through [Equation 1] provided below. ${U}_{p} = {U}_{p} \left({χ}_{p}\right) , {U}_{n} = {U}_{n} \left({χ}_{n}\right)$

In [Equation 1] provided above, a positive electrode potential U_{P} may be obtained based on a concentration X_{P} of solid-phase lithium ions for the positive electrode, and a negative electrode potential Uₙ may be obtained based on a concentration Xₙ of solid-phase lithium ions for the negative electrode.

In this regard, the model computing unit 123 may obtain the concentration X_{P} of solid-phase lithium ions for the positive electrode and the concentration Xₙ of solid-phase lithium ions for the negative electrode, as described in [Equation 2] to [Equation 7] provided below.

In relation to obtaining the concentration of lithium ions, the model computing unit 123 may determine the positive electrode OCV change profile and the negative electrode OCV change profile through the OCV model described through [Equation 2] and [Equation 3]. ${c}_{s , max , p} {L}_{p} {A}_{c} {ε}_{s , p} \frac{F}{3600} {χ}_{p , BOL} + {Q}_{offset , p 0} = {Q}_{CCB} \left({χ}_{p , BOL}\right)$ ${c}_{s , max , n} {L}_{n} {A}_{c} {ε}_{s , n} \frac{F}{3600} {χ}_{n , BOL} + {Q}_{offset , n 0} = {Q}_{CCB} \left({χ}_{n , BOL}\right)$

In the foregoing [Equation 2], the positive electrode OCV change profile Qccb (X_{p, BOL}) may be determined based on a sum of a theoretical capacity of the positive electrode and an initial offset of the positive electrode in a fresh state where aging does not occur.

In the foregoing [Equation 3], the negative electrode OCV change profile Qccb (X_{n, BOL}) may be determined based on a sum of a theoretical capacity of the negative electrode and an initial offset of the negative electrode in a fresh state where aging does not occur.

In this regard the model computing unit 123 may compute the initial offset of the negative electrode through the OCV model described based on [Equation 4] and [Equation 5]. $\begin{matrix}{Q}_{CCB} \left({χ}_{p {, SCC}_{FC}}\right) = {Q}_{CCB} \left({χ}_{n {, SCC}_{FC}}\right) , 0 < {SOC}_{FC} < 1 \\ where , {χ}_{i {, SCC}_{FC}} = {χ}_{i , SCC 0} + {SOC}_{FC} \left({χ}_{i , SCC 100}-{χ}_{i , SCC 0}\right)\end{matrix}$ $\begin{matrix}{Q}_{offset , p 0} = 0 \\ {Q}_{offset , n 0} = {c}_{s , max , 0} {L}_{p} {A}_{c} {ε}_{s , 0} \frac{F}{3600} {χ}_{p , S 0 C 0 , BOL} - {C}_{s , max , n} {L}_{n} {A}_{c} {ε}_{s , p} \frac{F}{3600} {χ}_{n , S 0 C 0 , BOL}\end{matrix}$

Based on a condition that a continuous charge balance Q_{CCB} (X_{p, SOCFC}) with respect to the positive electrode potential of the full-cell battery and a continuous charge balance Q_{CCB} (X_{n, SOCFC}) with respect to the negative electrode potential of the full-cell battery, described in [Equation 4], are the same as each other and an assumption that an initial offset Q_{offset, p0} of the positive electrode in the fresh state, described in [Equation 5], is '0', the initial offset Q_{offset, p0} of the negative electrode may be computed.

In addition, the model computing unit 123 may obtain the concentration of the solid-phase lithium ions for the electrode through the OCV model described based on [Equation 6] and [Equation 7]. ${Q}_{CCB} \left({χ}_{p}\right) = {c}_{s , max , p} {L}_{p} {A}_{c} {ε}_{s , p} \frac{F}{3600} {χ}_{p} + {Q}_{side , p \left(1\right)}$${Q}_{CCB} \left({χ}_{n}\right) = {c}_{s , max , r} {L}_{r} {A}_{c} {ε}_{s , r} \frac{F}{3600} {χ}_{n} + {Q}_{offset , n 0} + {Q}_{s , ce , r \left(t\right)}$

The concentration X_{P} of solid-phase lithium ions for the positive electrode may be computed using [Equation 6], and the concentration Xₙ of solid-phase lithium ions for the negative electrode may be computed using [Equation 7].

The model computing unit 123 may compute the electrode potential through the OCV model described based on [Equation 8] to [Equation 11]. $\begin{matrix}{U}_{sc} \left({Q}_{CCB}\right) = {U}_{p} \left(\frac{3600}{F}\frac{1}{{c}_{s , max , p} {L}_{p} {A}_{c} {ε}_{s , p}}\left({Q}_{CCB}-{Q}_{side , p}\left(t\right)\right)\right) \\ - {U}_{n} \left(\frac{3600}{F}\frac{1}{{c}_{s , max , n} {L}_{n} {A}_{c} {ε}_{s , n}}\left({Q}_{CCB}-{Q}_{offset , n 0}-{Q}_{side , n}\left(t\right)\right)\right)\end{matrix}$

In this regard, the model computing unit 123 may put the concentration of solid-phase lithium ions for the electrode, computed using [Equation 6] and [Equation 7], into [Equation 1], as can be seen from [Equation 8].

The model computing unit 123 may compute a full-cell potential U_{FC, SOC0} at an SOC of 0 % and a full-cell potential U_{FC, SOC100} at an SOC of 100 %, as in [Equation 9] provided below. $\begin{matrix}{U}_{FC , SOC 100} = {U}_{p} {\left.\left({χ}_{p , SOC 100}\right)\right|}_{t - 0} - {U}_{r} {\left.\left({χ}_{p , SOC 100}\right)\right|}_{z - 0} = {U}_{p} {\left.\left({χ}_{p , SOC 100}^{′}\right)\right|}_{t - t ′} - {U}_{p} {\left.\left({χ}_{r , SOC 100}^{′}\right)\right|}_{t - t ′} \\ {U}_{FC , SOC 0} = {U}_{p} {\left.\left({χ}_{p , SOC 0}\right)\right|}_{t - 0} - {U}_{r} {\left.\left({χ}_{n , SOC 0}\right)\right|}_{t - 0} = {U}_{p} {\left.\left({χ}_{o , SOC 0}^{′}\right)\right|}_{t - t ′} - {U}_{r} {\left.\left({χ}_{r , SOC 0}^{′}\right)\right|}_{t - t ′}\end{matrix}$

The model computing unit 123 may compute an electrode potential for a point on a charge balance axis where the full-cell potential U_{FC, SOC0} at an SOC of 0 % and the full-cell potential U_{FC, SOC100} at an SOC of 100 % correspond to preset values, as in [Equation 10] and [Equation 11] provided below. $\begin{matrix}{U}_{i} \left({χ}_{i {, SOC}_{10}}′\right) {I}_{l - 1 ′} = {U}_{i} \left({χ}_{i , SOC 0}^{′}+{SOC}_{FC}\left({χ}_{i , SOC 100}^{′}-{χ}_{i , SOC 0}^{′}\right)\right) \\ where , {x}_{i , SOC 100} ′ and {x}_{i , SOC 0} ′ are dependent on {Q}_{side , r} \left(t\right) and {Q}_{side , p} \left(t\right) \\ {U}_{i} \left(t\right) = {U}_{i} \left({SOC}_{FC}{, Q}_{side , n}\left(t\right){, Q}_{side , p}\left(t\right)\right)\end{matrix}$

According to various embodiments, the model computing unit 123 may obtain a side reaction state based on a potential of an electrode.

According to an embodiment, the model computing unit 123 may obtain the side reaction state by using the potential of the electrode (e.g., the equilibrium potential of the negative electrode and the positive electrode and the capacity differential value of the equilibrium potential) and the side reaction amount of the electrode.

For example, the model computing unit 123 may obtain the side reaction state of the electrode by using the OCV model described based on [Equation 11] provided below. For example, the model computing unit 123 may use ordinary differential equations that integrate the side reaction amount of the electrode by using the potential of the electrode to obtain the side reaction state of the electrode. $\begin{matrix}\frac{d}{dt} {Q}_{s . dc . o} \left(t\right) = \\ \frac{F}{3600} {A}_{o} {L}_{p} {a}_{s . o} {J}_{CEJ . o} exp \left[+\frac{{α}_{CEJ}}{RT}\left({U}_{p}\left({SOC}_{FC},{Q}_{side , n}\left(t\right),{Q}_{side , o}\left(t\right)\right)-{U}_{CEI}\right)\right] exp \left[-{γ}_{CEJ}{Q}_{side , p}\left(t\right)\right] \\ \frac{d}{dt} {Q}_{s ⋅ de , r} \left(t\right) = \\ \frac{F}{3600} ⋅ {A}_{c} {L}_{n} {a}_{s , n} {J}_{SEI , D} \left(1+{X}_{cas , un}{c}_{un , sol}\left(t\right)\right) \times exp \left[-\begin{matrix}{α}_{SFI} \\ RT\end{matrix}\left({U}_{n}\left({SOC}_{fC},{Q}_{s . cs . n}\left(t\right),{Q}_{s . ce , p}\left(t\right)\right)-{U}_{SEI}\right)\right] exp \left[-{γ}_{SE}{Q}_{s . cs . p}\left(t\right)\right] \\ \frac{d}{dt} {C}_{Mn , sol} \left(t\right) = \\ {a}_{s , n} \frac{{ε}_{n} {L}_{n}}{{ε}_{n} {L}_{n} + {ε}_{s} {L}_{s} + {ε}_{p} {L}_{p}} {J}_{Mn , 0} exp \left[+\frac{{α}_{Mn}}{RT}\left({U}_{p}\left({SOC}_{FC},{Q}_{side , n}\left(t\right),{Q}_{side , p}\left(t\right)\right)-{U}_{Mn}\right)\right] \\ With the initial conditions \\ {Q}_{side , p} \left(t=0\right) = 0 \\ {Q}_{side , n} \left(t=0\right) = 0 \\ {C}_{Mn , sol} \left(t=0\right) = 0 \\ Where , \\ {γ}_{SEI \left|CEI\right.} = \frac{1}{2} \frac{{M}_{SEI \left|CEI\right.}}{{ρ}_{SEI \left|CEI\right.}} \frac{3600}{F} \frac{1}{{S}_{i}} {λ}_{SEI \left|CEI\right.} \left[1/Ah\right]\end{matrix}$

In another example, the model computing unit 123 may obtain the side reaction state of the electrode by using the OCV model described based on [Equation 12] provided below. For example, the model computing unit 123 may approximate the side reaction amount based on an assumption that the equilibrium potential of the electrode does not change greatly with aging of the battery 110, and obtain the side reaction state of the electrode by using the side reaction amount. $\begin{matrix}\frac{d}{dt} {Q}_{side , p} \left(t\right) = {K}_{CEI} exp \left(-{γ}_{CEI}{Q}_{side , p}\left(t\right)\right) \\ \frac{d}{dt} {Q}_{side , n} \left(t\right) = {K}_{SEI} \left(1-{K}_{Mn}t\right) exp \left(-{γ}_{SEI}{Q}_{side , n}\left(t\right)\right) \\ where , \\ {K}_{CEI} = \frac{F}{3600} {A}_{c} {L}_{p} {a}_{s , p} {J}_{CEI , 0} exp \left[+\frac{{α}_{CEI}}{RT}\left({U}_{p}\left({SOC}_{FC},{Q}_{side , n}\left(t=0\right),{Q}_{side , p}\left(t=0\right)\right)-{U}_{CEI}\right)\right] \\ {K}_{SEI} = \frac{F}{3600} {A}_{c} {L}_{n} {a}_{s , n} {J}_{SEI , 0} exp \left[-\frac{{α}_{SEI}}{RT}\left({U}_{p}\left({SOC}_{FC},{Q}_{side , n}\left(t=0\right),{Q}_{side , p}\left(t=0\right)\right)-{U}_{SEI}\right)\right] \\ {K}_{Mn} = {a}_{s , n} \frac{{ε}_{n} {L}_{n}}{{ε}_{n} {L}_{n} + {ε}_{s} {L}_{s} + {ε}_{p} {L}_{p}} {J}_{Mn , 0} exp \left[+\frac{{α}_{Mn}}{RT}\left({U}_{p}\left({SOC}_{FC},{Q}_{side , n}\left(t=0\right),{Q}_{side , p}\left(t=0\right)\right)-{U}_{Mn}\right)\right] \\ {Q}_{side , p} \left(t\right) = \frac{1}{{γ}_{CEI}} ln \left[1+{γ}_{CEI} {K}_{CEI} t\right] \\ {Q}_{side , n} \left(t\right) = \frac{1}{{γ}_{SEI}} ln \left[1+{γ}_{SEI} {K}_{SEI} t+{γ}_{SEI}{K}_{SEI} {K}_{Mn}{t}^{2}\right]\end{matrix}$

According to various embodiments, the deterioration estimating unit 125 may estimate deterioration of the battery 110 based on the side reaction state of the electrode, obtained by the model computing unit 123.

According to an embodiment, the deterioration estimating unit 125 may obtain a state of health (SOH) and/or a self-discharge voltage of the battery 110.

In this regard, the deterioration estimating unit 125 may estimate deterioration of the battery 110 by using the OCV model described based on [Equation 13] to [Equation 15]. ${Q}_{Loss} \left(t\right) = {Q}_{side , n} \left(t\right) - {Q}_{side , p} \left(t\right)$ $SOH \left(t\right) = 1 - \frac{{Q}_{side , n} \left(t\right) - {Q}_{side , p} \left(t\right)}{{Q}_{FC} \left(t=0\right)}$ $\begin{matrix}{ΔV}_{set , IC} = {ΔU}_{se f , p} - {ΔU}_{set , n} = {ΔQ}_{so f , p} {\left.\frac{{δU}_{p}}{δQ}\right|}_{SOC ⋅ c} {\left.-{ΔQ}_{s co , r}\frac{δ {U}_{r}}{δ Q}\right|}_{{SOC}_{IO}} \\ \frac{{δU}_{i}}{δQ} = - \frac{{δU}_{i}}{δ χ} \frac{δ}{δ} \frac{{χ}_{i}}{Q} = - \frac{3600}{{Fc}_{s . i , max} {A}_{c} {L}_{i} {ε}_{s . i}} \frac{{δU}_{i}}{δ {χ}_{i}}\end{matrix}$

For example, based on a relationship between a side reaction described in [Equation 13] and a capacity reduction of the battery 110 and [Equation 14], the state of health of the battery 110 may be obtained and a self-discharge voltage may be obtained based on [Equation 15].

According to various embodiments, the state identifying unit 127 may determine the state of the battery 110 based on an estimation result of the deterioration estimating unit 125.

According to an embodiment, the state identifying unit 127 may determine the degradation state of the battery 110 based on the state of health and/or the self-discharge voltage of the battery 110. A determination result of the state identifying unit 127 may be output through the output device 130.

As described above, the diagnosis system 100 may include the battery 110, the diagnosis apparatus 120, and the output device 130. However, this is merely an example, and various embodiments are not limited thereto. For example, at least one of the components described with reference to FIG. 1A may be omitted from components of the diagnosis system 100 or other components than the above-described components may be added as components of the diagnosis system. For example, various types of loads configured to operate as power supplied from the battery 110 may be added as components of the diagnosis system 110.

The components of the diagnosis apparatus 120 may not be limited to the components shown in FIG. 1B. For example, at least one of the components shown in FIG. 1B may be omitted from the components of the diagnosis system 120 or one or more other components may be added as components of the diagnosis apparatus 120. At least one of the above-described components may be integrated with other components. Such a diagnosis apparatus 120 may be provided as a component of a battery management system or as a separate component distinguished from the battery management system.

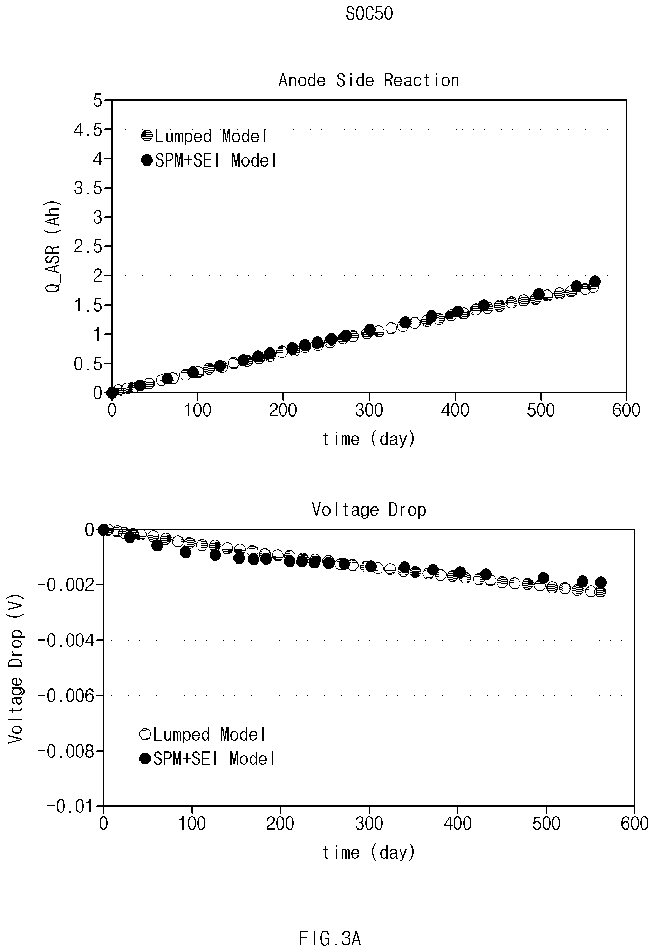

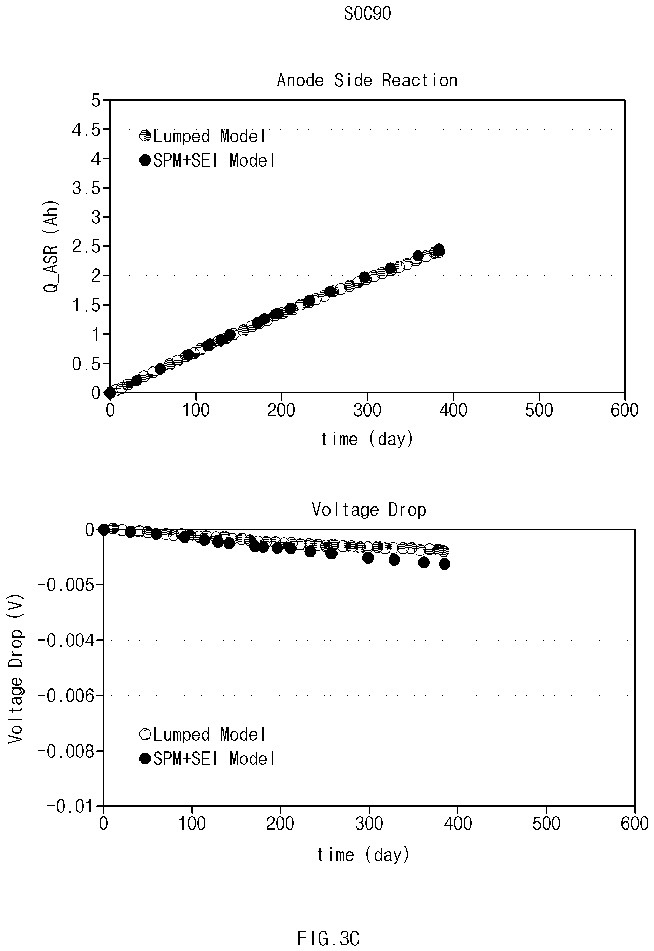

FIGS. 3A to 3G show a result of performance comparison between a diagnosis apparatus according to various embodiments and a diagnosis apparatus according to a comparative embodiment.

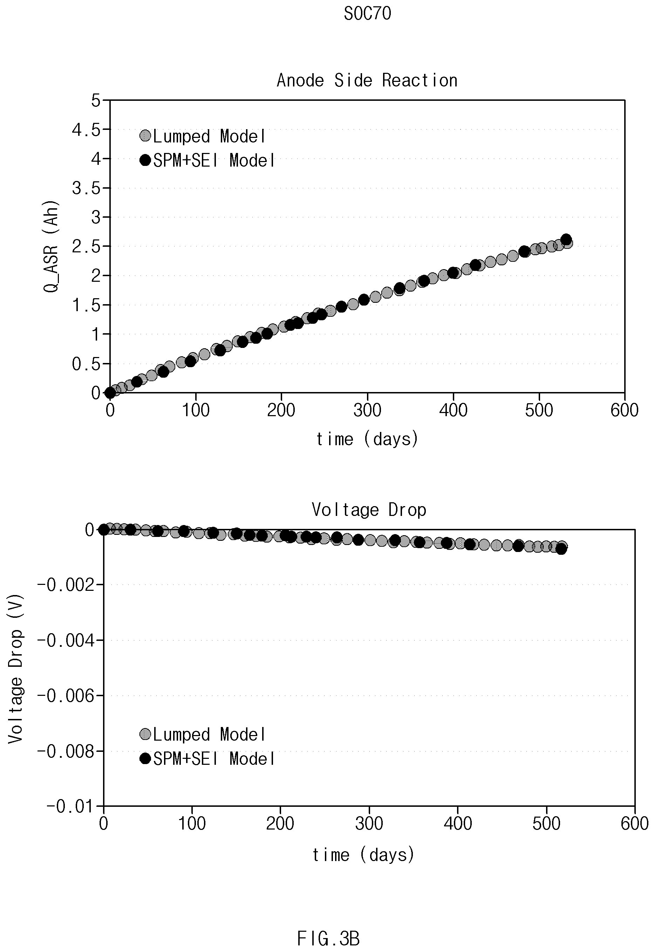

Referring to FIGS. 3A and 3B, it can be seen that a diagnosis result of a diagnosis apparatus using a physics-based model (e.g., an SPM model) according to a comparative embodiment and a diagnosis result of a diagnosis apparatus using a model (e.g., a lumped OCV model) modeled based on a higher level of contraction than the physics-based model according to various embodiments are significantly similar to each other.

In particular, in a first charge state (e.g., SOC 50) of the battery 100, a side reaction state and a discharge voltage measured in the diagnosis apparatus according to various embodiments are similar to a result measured in the diagnosis apparatus according to a comparative embodiment. However, it may be seen that measurement periods of the side reaction state and the discharge voltage are shorter in the diagnosis apparatus according to various embodiments than in the diagnosis apparatus according to the comparative embodiment.

Such a measurement result may be equally identified in a second charge state (e.g., SOC 70) and a third charge state (e.g., SOC 90) of the battery 100. It may be seen from this point that the diagnosis apparatus according to various embodiments may derive a measurement result similar to the diagnosis apparatus according to the comparative embodiment, but more quickly derive a measurement result than the diagnosis apparatus according to the comparative embodiment.

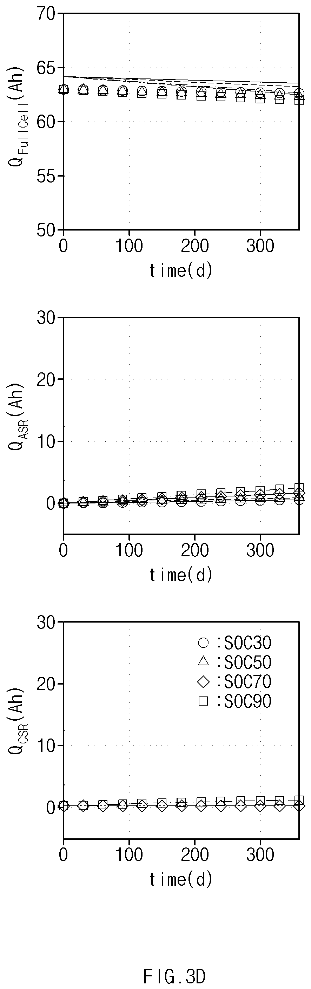

Referring to FIGS. 3D to 3F, it may be seen that a measurement result of the diagnosis apparatus according to various embodiments and a measurement result of the diagnosis apparatus according to the comparative embodiment are similar to each other even in an aging process performed after manufacturing of the battery 100.

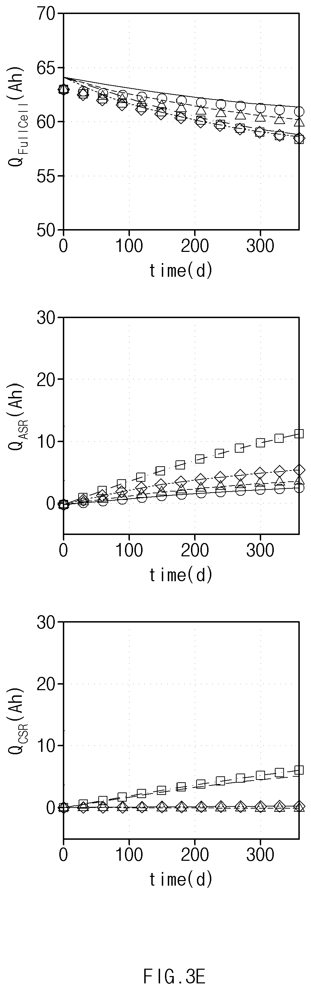

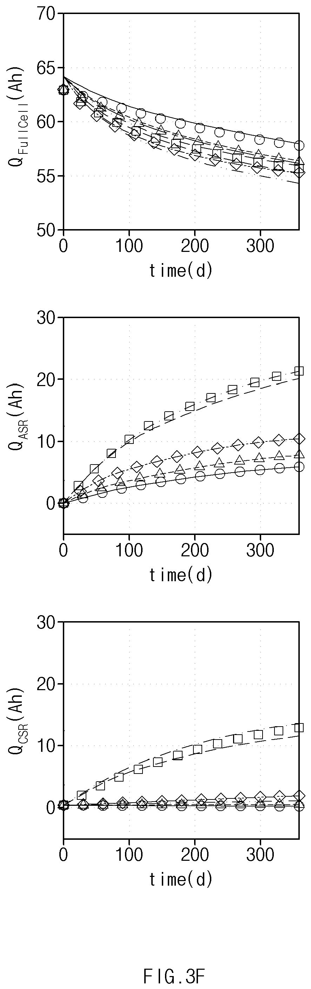

For example, FIG. 3D shows a side reaction state (e.g., a side reaction state QFULLCELL, a negative electrode side reaction state QASR, and a positive electrode side reaction state QCSR of a full-cell electrode) of an electrode, measured in a state of aging batteries of various SOC levels (e.g., SOCs of 30, 50, 70, and 90) under a first temperature condition (e.g., a temperature of 25 'C) for one year (calendar aging). FIG. 3E shows a side reaction state of an electrode, measured in an aging state under a second temperature condition (e.g., a temperature of 45 'C), and FIG. 3F shows a side reaction state of an electrode, measured in an aging state under a third temperature condition (e.g., a temperature of 60 'C). In FIGS. 3D to 3F, a circle indicates a measurement result of the diagnosis apparatus according to the comparative embodiment, a solid line indicates a measurement result of the diagnosis apparatus according to various embodiments, and a dashed line indicates an analytical solution of the diagnosis apparatus according to various embodiments.

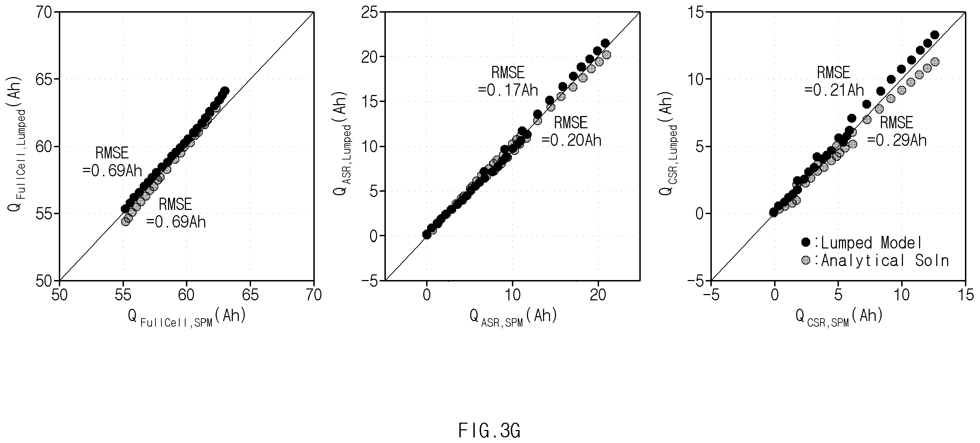

Referring to FIG. 3G, as can be seen from a low error rate of the diagnosis apparatus according to various embodiments, the diagnosis apparatus according to various embodiments may derive a superior measurement result.

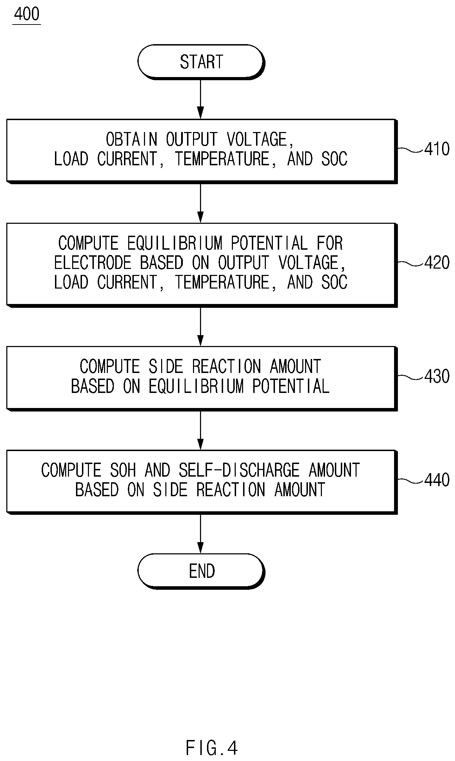

FIG. 4 is a flowchart showing a battery diagnosis operation of a diagnosis system according to various embodiments. Operations in the following embodiment may be sequentially performed, but may not be necessarily sequentially performed. For example, the order of operations may be changed and at least two operations may be performed in parallel.

Referring to FIG. 4, the diagnosis system 100 (or the diagnosis apparatus 120) according to various embodiments may obtain battery information related to the battery 110, in operation 410. According to an embodiment, the diagnosis system 100 may obtain a voltage, a current, a temperature, and an SOC of the battery 110 as battery information. In addition, the diagnosis system 100 may obtain a side reaction amount accumulated in the electrode as the battery information.

According to various embodiments, the diagnosis system 100 (or the diagnosis apparatus 120) may compute an equilibrium potential for the electrode based on the obtained battery information, in operation 420. According to an embodiment, the diagnosis system 100 may obtain the equilibrium potential based on a concentration of solid-phase lithium ions for the electrode. In this regard, the diagnosis system 100 may obtain the concentration of solid-phase lithium ions for the electrode based on an OCV model (e.g., a lumped OCV model) described in [Equation 2] to [Equation 10].

According to various embodiments, the diagnosis system 100 (or the diagnosis apparatus 120) may compute a side reaction state (or a side reaction rate) based on the equilibrium potential, in operation 430. According to an embodiment, the diagnosis system 100 may use a functional dependence of the side reaction state (e.g., the side reaction rate) for the equilibrium potential for the electrode. In this regard, the diagnosis system 100 may compute the side reaction state through the OCV model described in [Equation 11] and/or [Equation 12].

According to various embodiments, the diagnosis system 100 (or the diagnosis apparatus 120) may estimate deterioration of the battery 100 based on the side reaction state of the electrode, in operation 440. According to an embodiment, the diagnosis system 100 may obtain an SOH and/or a self-discharge voltage of the battery 110. In this regard, the diagnosis system 100 may estimate the state of health and/or the self-discharge voltage of the battery 110 by using the OCV model described in [Equation 13] to [Equation 15].

According to various embodiments, the diagnosis system 100 (or the diagnosis apparatus 120) may determine the state of the battery 110 based on the state of health and/or the self-discharge voltage of the battery 110. According to an embodiment, the diagnosis system 100 may determine the degradation state of the battery 110 and output a determination result through the output device 130.

The above description is merely illustrative of the technical idea of the present invention, and various modifications and variations will be possible without departing from the scope of the present invention by those of ordinary skill in the art to which the present invention pertains.

## Claims

1. A diagnosis system (100) for diagnosing a state of a battery, the diagnosis system (100) comprising:
the battery (110); and
a diagnosis apparatus (120) configured to diagnose the state of the battery (110);
wherein the diagnosis apparatus (120) is further configured to:
predict a side reaction rate of an electrode, based on an open circuit voltage, OCV, model defined with a state of charge, SOC, of the battery (110) and an accumulative side reaction amount of the electrode;
predict a degradation state of the battery (110) based on the side reaction rate; **characterised in that** the diagnosis apparatus is further configured to:
obtain an equilibrium potential for the electrode based on the OCV model; and predict the side reaction rate of the electrode based on the equilibrium potential.

2. The diagnosis system of claim 1, wherein the diagnosis apparatus (120) is further configured to obtain the equilibrium potential of the electrode based on a concentration of solid-phase lithium ions for the electrode.

3. The diagnosis system of claim 1, wherein the diagnosis apparatus (120) is further configured to predict the side reaction rate by using ordinary differential equations that integrate a side reaction amount of the electrode with respect to time by using a potential of the electrode.

4. The diagnosis system of claim 1, wherein the diagnosis apparatus (120) is further configured to predict the side reaction rate by approximating a side reaction amount of the electrode.

5. The diagnosis system of claim 1, wherein the diagnosis apparatus (120) is further configured to:
obtain a state of health, SOH, and a self-discharge voltage of the battery (110), based on the predicted side reaction rate; and
predict the degradation state of the battery (110) based on the state of health and the self-discharge voltage of the battery (110).

6. The diagnosis system of claim 5, further comprising an output device (130),
wherein the diagnosis apparatus (120) is further configured to output the predicted degradation state through the output device (130).

7. The diagnosis system of claim 1, wherein the diagnosis apparatus (120) is further configured to:
obtain information related to at least one of a voltage, a current, and a temperature of the battery (110); and
obtain the state of charge of the battery (110) and the accumulative side reaction amount of the electrode based on the obtained information.

8. An operating method of a diagnosis system for diagnosing a state of a battery (110), the operating method comprising:
predicting a side reaction rate of the battery, based on an open circuit voltage, OCV, model defined with a state of charge, SOC, of the battery (110) and an accumulative side reaction amount of an electrode;
predicting a degradation state of the battery (110) based on the side reaction rate; wherein the operating method is **characterised by**:
obtaining an equilibrium potential for the electrode based on the OCV model;
and
predicting the side reaction rate of the electrode based on the equilibrium potential.

9. The operating method of claim 8, further comprising obtaining the equilibrium potential of the electrode based on a concentration of solid-phase lithium ions for the electrode.

10. The operating method of claim 8, further comprising predicting the side reaction rate by using ordinary differential equations that integrate a side reaction amount of the electrode with respect to time by using a potential of the electrode.

11. The operating method of claim 8, further comprising predicting the side reaction rate by approximating the side reaction amount of the electrode.

12. The operating method of claim 8, further comprising:
obtaining a state of health, SOH, and a self-discharge voltage of the battery (110), based on the predicted side reaction rate; and
predicting the degradation state of the battery (110) based on the state of health and the self-discharge voltage of the battery (110).

13. The operating method of claim 12, further comprising outputting the predicted degradation state through an output device (130).

## Patentansprüche

1. Diagnosesystem (100) zum Diagnostizieren eines Zustands einer Batterie, wobei das Diagnosesystem (100) umfasst:
die Batterie (110); und
eine Diagnoseeinrichtung (120), die konfiguriert ist, um den Zustand der Batterie (110) zu diagnostizieren;
wobei die Diagnoseeinrichtung (120) ferner konfiguriert ist zum:
Vorhersagen einer Nebenreaktionsrate einer Elektrode, basierend auf einem Leerlaufspannungs-OCV-Modell, das mit einem Ladezustand, SOC, der Batterie (110) und einer akkumulierten Nebenreaktionsmenge der Elektrode definiert ist;
Vorhersagen eines Verschlechterungszustands der Batterie (110) basierend auf der Nebenreaktionsrate;
**dadurch gekennzeichnet, dass** die Diagnoseeinrichtung ferner zu Folgendem konfiguriert ist:
Erhalten eines Gleichgewichtspotentials für die Elektrode basierend auf dem OCV-Modell; und
Vorhersagen der Nebenreaktionsrate der Elektrode basierend auf dem Gleichgewichtspotential.

2. Diagnosesystem nach Anspruch 1, wobei die Diagnoseeinrichtung (120) ferner konfiguriert ist, um das Gleichgewichtspotential der Elektrode basierend auf einer Konzentration von Festphasen-Lithiumionen für die Elektrode zu erhalten.

3. Diagnosesystem nach Anspruch 1, wobei die Diagnoseeinrichtung (120) ferner konfiguriert ist, um die Nebenreaktionsrate unter Verwendung von gewöhnlichen Differentialgleichungen vorherzusagen, die eine Nebenreaktionsmenge der Elektrode in Bezug auf die Zeit unter Verwendung eines Potentials der Elektrode integrieren.

4. Diagnosesystem nach Anspruch 1, wobei die Diagnoseeinrichtung (120) ferner konfiguriert ist, um die Nebenreaktionsrate durch Annähern einer Nebenreaktionsmenge der Elektrode vorherzusagen.

5. Diagnosesystem nach Anspruch 1, wobei die Diagnoseeinrichtung (120) ferner konfiguriert ist zum:
Erhalten eines Gesundheitszustands, SOH, und einer Selbstentladespannung der Batterie (110), basierend auf der vorhergesagten Nebenreaktionsrate; und
Vorhersagen des Verschlechterungszustands der Batterie (110) basierend auf dem Gesundheitszustand und der Selbstentladespannung der Batterie (110).

6. Diagnosesystem nach Anspruch 5, ferner umfassend eine Ausgabevorrichtung (130), wobei die Diagnoseeinrichtung (120) ferner konfiguriert ist, um den vorhergesagten Verschlechterungszustand über die Ausgabevorrichtung (130) auszugeben.

7. Diagnosesystem nach Anspruch 1, wobei die Diagnoseeinrichtung (120) ferner konfiguriert ist zum:
Erhalten von Informationen, die sich auf mindestens eines von einer Spannung, einem Strom und einer Temperatur der Batterie (110) beziehen; und
Erhalten des Ladezustands der Batterie (110) und der akkumulierten Nebenreaktionsmenge der Elektrode basierend auf den erhaltenen Informationen.

8. Betriebsverfahren eines Diagnosesystems zum Diagnostizieren eines Zustands einer Batterie (110), wobei das Betriebsverfahren umfasst:
Vorhersagen einer Nebenreaktionsrate der Batterie, basierend auf einem Leerlaufspannungs-OCV-Modell, das mit einem Ladezustand, SOC, der Batterie (110) und einer akkumulierten Nebenreaktionsmenge einer Elektrode definiert ist;
Vorhersagen eines Verschlechterungszustands der Batterie (110) basierend auf der Nebenreaktionsrate;
wobei das Betriebsverfahren durch Folgendes gekennzeichnet ist:
Erhalten eines Gleichgewichtspotentials für die Elektrode basierend auf dem OCV-Modell; und
Vorhersagen der Nebenreaktionsrate der Elektrode basierend auf dem Gleichgewichtspotential.

9. Betriebsverfahren nach Anspruch 8, ferner umfassend das Erhalten des Gleichgewichtspotentials der Elektrode basierend auf einer Konzentration von Festphasen-Lithiumionen für die Elektrode.

10. Betriebsverfahren nach Anspruch 8, ferner umfassend das Vorhersagen der Nebenreaktionsrate unter Verwendung von gewöhnlichen Differentialgleichungen, die eine Nebenreaktionsmenge der Elektrode in Bezug auf die Zeit unter Verwendung eines Potentials der Elektrode integrieren.

11. Betriebsverfahren nach Anspruch 8, ferner umfassend das Vorhersagen der Nebenreaktionsrate durch Annähern einer Nebenreaktionsmenge der Elektrode.

12. Betriebsverfahren nach Anspruch 8, ferner umfassend:
Erhalten eines Gesundheitszustands, SOH, und einer Selbstentladespannung der Batterie (110), basierend auf der vorhergesagten Nebenreaktionsrate; und
Vorhersagen des Verschlechterungszustands der Batterie (110) basierend auf dem Gesundheitszustand und der Selbstentladespannung der Batterie (110).

13. Betriebsverfahren nach Anspruch 12, ferner umfassend das Ausgeben des vorhergesagten Verschlechterungszustands über eine Ausgabevorrichtung (130).

## Revendications

1. Système de diagnostic (100) pour diagnostiquer un état d'une batterie, le système de diagnostic (100) comprenant :
la batterie (110) ; et
un appareil de diagnostic (120) configuré pour diagnostiquer l'état de la batterie (110) ;
dans lequel l'appareil de diagnostic (120) est en outre configuré pour :
prédire une vitesse de réaction secondaire d'une électrode, sur la base d'un modèle de tension en circuit ouvert, OCV, défini avec un état de charge, SOC, de la batterie (110) et une quantité de réaction secondaire cumulative de l'électrode ;
prédire un état de dégradation de la batterie (110) sur la base de la vitesse de réaction secondaire ;
**caractérisé en ce que** l'appareil de diagnostic est en outre configuré pour :
obtenir un potentiel d'équilibre pour l'électrode sur la base du modèle OCV ; et
prédire la vitesse de réaction secondaire de l'électrode sur la base du potentiel d'équilibre.

2. Le système de diagnostic selon la revendication 1, dans lequel l'appareil de diagnostic (120) est en outre configuré pour obtenir le potentiel d'équilibre de l'électrode sur la base d'une concentration d'ions lithium en phase solide pour l'électrode.

3. Le système de diagnostic selon la revendication 1, dans lequel l'appareil de diagnostic (120) est en outre configuré pour prédire la vitesse de réaction secondaire en utilisant des équations différentielles ordinaires qui intègrent une quantité de réaction secondaire de l'électrode par rapport au temps en utilisant un potentiel de l'électrode.

4. Le système de diagnostic selon la revendication 1, dans lequel l'appareil de diagnostic (120) est en outre configuré pour prédire la vitesse de réaction secondaire en approximant une quantité de réaction secondaire de l'électrode.

5. Le système de diagnostic selon la revendication 1, dans lequel l'appareil de diagnostic (120) est en outre configuré pour :
obtenir un état de santé, SOH, et une tension d'autodécharge de la batterie (110), sur la base de la vitesse de réaction secondaire prédite ; et
prédire l'état de dégradation de la batterie (110) sur la base de l'état de santé et de la tension d'autodécharge de la batterie (110).

6. Le système de diagnostic selon la revendication 5, comprenant en outre un dispositif de sortie (130), dans lequel l'appareil de diagnostic (120) est en outre configuré pour délivrer en sortie l'état de dégradation prédit par l'intermédiaire du dispositif de sortie (130).

7. Le système de diagnostic selon la revendication 1, dans lequel l'appareil de diagnostic (120) est en outre configuré pour :
obtenir des informations relatives à au moins l'un(e) d'une tension, d'un courant et d'une température de la batterie (110) ; et
obtenir l'état de charge de la batterie (110) et la quantité de réaction secondaire cumulative de l'électrode sur la base des informations obtenues.

8. Procédé de fonctionnement d'un système de diagnostic pour diagnostiquer un état d'une batterie (110), le procédé de fonctionnement comprenant :
la prédiction d'une vitesse de réaction secondaire de la batterie, sur la base d'un modèle de tension en circuit ouvert, OCV, défini avec un état de charge, SOC, de la batterie (110) et une quantité de réaction secondaire cumulative d'une électrode ;
la prédiction d'un état de dégradation de la batterie (110) sur la base de la vitesse de réaction secondaire ;
dans lequel le procédé de fonctionnement est **caractérisé par** :
l'obtention d'un potentiel d'équilibre pour l'électrode sur la base du modèle OCV ; et
la prédiction de la vitesse de réaction secondaire de l'électrode sur la base du potentiel d'équilibre.

9. Le procédé de fonctionnement selon la revendication 8, comprenant en outre l'obtention du potentiel d'équilibre de l'électrode sur la base d'une concentration d'ions lithium en phase solide pour l'électrode.

10. Le procédé de fonctionnement selon la revendication 8, comprenant en outre la prédiction de la vitesse de réaction secondaire en utilisant des équations différentielles ordinaires qui intègrent une quantité de réaction secondaire de l'électrode par rapport au temps en utilisant un potentiel de l'électrode.

11. Le procédé de fonctionnement selon la revendication 8, comprenant en outre la prédiction de la vitesse de réaction secondaire en approximant une quantité de réaction secondaire de l'électrode.

12. Le procédé de fonctionnement selon la revendication 8, comprenant en outre :
l'obtention d'un état de santé, SOH, et d'une tension d'autodécharge de la batterie (110), sur la base de la vitesse de réaction secondaire prédite ; et
la prédiction de l'état de dégradation de la batterie (110) sur la base de l'état de santé et de la tension d'autodécharge de la batterie (110).

13. Le procédé de fonctionnement selon la revendication 12, comprenant en outre la délivrance en sortie de l'état de dégradation prédit par l'intermédiaire d'un dispositif de sortie (130).
